# EUROPEAN PATENT SPECIFICATION

(11) **EP 1 370 709 B1**
(45) Date of publication and mention of the grant of the patent: **10.12.2008**
(21) Application number: 02701788.8
(22) Date of filing: 26.02.2002
(51) Int. Cl.: C23C 16/27, C30B 25/00

(54) **Method and Apparatus for Synthesizing Diamond by Chemical Vapor Deposition**
Verfahren und Vorrichtung zur Diamantsynthese durch chemische Dampfabscheidung
Procédé et dispositif de synthèse de diamant par dépôt chimique en phase vapeur

(30) Priority: 26.02.2001 KR 2001009598
(43) Date of publication of application: 17.12.2003
(73) Proprietor: Precision Diamond Co., Ltd., Eumbong-myeon Asan-si Chungcheongnam-do 336-863 (KR)
(72) Inventor: CHAE, Ki-Woong, Cheonan-shi 330-260 Chungcheongnam-do; (KR)
(74) Representative: Needle, Jacqueline
(86) International application number: PCT/KR2002/000315
(87) International publication number: WO 2002/068709

(56) References cited:
- JP-A- 1 072 992
- JP-A- 7 291 793
- US-A- 4 958 592
- US-A- 4 970 986

## Description

The present invention relates to a method and apparatus for synthesizing diamond by chemical vapor deposition.

Diamond has high industrial applicability because of its excellent hardness, thermal conductivity, electric insulating property, optical property and other chemically stable physical characteristics.

The importance of diamond has been emphasized since the 1980s when a chemical vapor deposition process based on hydrogen and methane gas has been used for its synthesis.

Various methods for efficiently synthesizing diamond via chemical vapor deposition processes have been suggested. Notable amongst these methods are methods for depositing diamond by chemical vapor deposition using hot metal filaments. Such methods are simple in their equipment and economical because diamond can be synthesized in larger sizes. Due to these characteristics, this method is actively studied.

Generally, it has been known that diamond can be synthesized when the metal filament is maintained at a temperature of 1800∼2500°C, a base substrate is at a temperature of 700∼1100°C, and a gas is then injected during the process of synthesizing diamond using hot filament.

However, this method has problems because the metal filament needs to be maintained at a high temperature. These problems are discussed below.

To synthesize diamond requires the diamond to be maintained at a temperature over 2000°C. This means that the length of the metal filament is continuously changed by thermal expansion.

The filament becomes slack at the high temperature, because the filament is deformed by its weight at the high temperature.

In other words, it is necessary to control properly the temperature of diamond for being synthesized. Additionally, it is also important to maintain the region for synthesizing diamond at a settled temperature for hours because the diamond has the slow growth rate of 0.5-2 µm/h.

However, the phenomenon wherein the filament becomes slack or broken makes it impossible to control the temperature of diamond for being synthesized. The phenomenon also causes the temperature gradient, and makes it impossible to regulate the distance between the filament and the base substrate wherein diamond is synthesized. As a result, diamond cannot be synthesized.

Another problem is the carburization of metal filament while the process of synthesizing diamond is performed under the carbonizing (i.e. methane gas) condition.

If the metal filament is previously carbonized, its volume is expanded and its form is seriously distorted. This phenomenon causes the filament to be changed in its length and to have internal stress. The previously carbonized filament has the same brittleness as that of ceramics, and, as a result, the filament tends to be broken by external force or impact.

If it is considered that the general diameter of filaments used in synthesizing diamond is 0.02∼0.5mm, it is apparent that it is difficult to maintain the carbonized filament without breakage.

Tungsten is generally used as the filament. Tungsten carbide is formed by the carburization of the filament, thereby resulting in a brittleness as that of ceramics.

The brittle filament is broken by its expansion and contraction when the filament used in synthesizing diamond is heated to a high temperature and then cooled to an ambient temperature.

It is very important to control or prevent this problem for a chemical vapor deposition process.

The brittleness also causes the filament to be limited to a single use for synthesizing diamond.

The above-described problems of the filament cause more serious problems in designing equipment with a large area.

There have been various methods to prevent the hot filament from breakage by the brittleness resulting from becoming slack and from the carburization of the hot filament.

US-A-4,953,499 provides a pre-stressed curved filament to endure the thermal expansion and the carburization of the filament. However, this filament is easily broken when it is pre-stressed. The previously curved filament has internal stress and therefore tends to be arranged to an undesired direction and form by the rise in temperature.

Particularly, if the curved filament is placed on a mis-fixed electrode, it is changed into an undesired size and form by the carburization of the filament. As a result it is impossible to regulate the changed filament.

US-A-4,970,986 copes with thermal expansion of the metal filament by mounting individual springs on the filaments to provide tensile stress.
However, as the spring is mounted inside the apparatus for synthesizing diamond, it is impossible to regulate the spring while synthesizing diamond. Furthermore, since the spring has excessive stress, the extremely thin filament is easily broken.

Although a plug is mounted on the opposite side to regulate the stress, it is still difficult to regulate properly the individual stress of a plurality of filaments.

US-A-4,958,592 provides a method to regulate the transformation resulting from the thermal expansion and carburization of the filament by installing a complicated counterbalancing weight assembly on the filament which is located perpendicularly and generates heat.

However, this method still has many problems. The counterbalancing weight assembly has a bar which applies a tension to the filament. The bar is slipped down by a bearing and then connected to the end of a counterbalancing bar (lever). Counterbalancing weights are placed on the opposite side of this counterbalancing bar.

A supporting rod of the lever is hung on the synthetic equipment by a string. This counterbalancing weight assembly is easily fluctuated in every direction even by near small impact. As a result, it is impossible to adjust the filament.

Because a tensile bar is moved by the bearing, it is possible to control the weight in an up-and-down or circumferential movement but impossible to adjust the three-dimensional movement (swing or vibration) of the weight.

A perpendicularly mounted filament is connected to the complicated counterbalancing weight assembly (tensile bars, levers, weights) hung to the synthetic equipment. However, it is improper structure in synthesizing diamond with large size using a plurality of filaments.

US-A-5,833,753 and US-A-5,997,650 describe methods to move electrodes (movable electrodes) in which filaments are arranged and to regulate the tensile stress by installing a force regulator on the movable electrodes.

This method needs complicated subsidiary equipment and precision control to fix a plurality of filaments having identical length on the movable electrodes.

Korean patent No. 100,286 describes a method of absorbing the change in length of a filament during its thermal expansion by forming a hole on which the end of the filament is slipped to electrodes. A supporting bar is mounted between the electrodes in case the filament becomes slack. However, a lot of supporting bars are required, even if the length of the filaments gradually increases.

In Korean patent No. 105,943 the filament is formed into double lines twisted with several single ones. These filaments having a spiral form are contracted parallel with the lines during its carburization. In this way, it is possible to prevent the filament from becoming slack. However, it is desirable to use short filaments. If the filaments become longer, it is impossible to prevent the filament from becoming slack by its weight because of the limit in its contraction.

The above-described known methods all need intricate subsidiary equipment. These methods place their emphasis on preventing the filaments becoming slack and there is no consideration given to the usage count of the filaments.

Japan-A-01 072992 describes an apparatus for synthesizing diamond which uses a heated filament which is tensioned and stretched parallel to a base material. This is to broaden a region capable of coating.

Japan-A-07 291793 seeks to improve the crystallinity of diamond-like carbon and uses a filament system consisting of pairs of filaments extending in proximity to planar substrates.

The prior art described above does not consider the possibility of using filaments repeatedly, and, in many, the filaments have structural problems preventing repeated use.

The present invention seeks to provide apparatus for diamond synthesis by chemical vapor deposition which enables the hot filament to be used without breakage. The apparatus may enable repeated use.

According to a first aspect of the present invention there is provided a method for synthesizing diamond based on hydrogen and methane gas by chemical vapor deposition, the method using hot metal filaments as a heat source, the method using apparatus comprising a pair of conductive electrodes, each electrode having a flat surface on a top portion thereof and a curved surface on an outer side thereof, and a plurality of metal filaments placed over both electrodes to extend between the electrodes and such that each filament is in contact with both the flat surface and the curved surface of each electrode, wherein each end of each filament is weighted with individual weights in order to tension the filaments placed over the electrodes, the apparatus also comprising conductive cover plates mounting a region of each filament to the flat surface, the method comprising supplying electrical power to the filaments to heat them and to synthesize diamond, wherein the region of each filament enclosed by the conductive cover plate and the flat surface does not generate heat.

With methods of the invention, the filaments are smoothly hanged to both electrodes according to the flat surface and the curved surface without being fixed so that the filaments can be freely moved according to thermal changes such as heat expansion, contraction and carbonation.

The invention also extends to apparatus for synthesizing diamond based on hydrogen and methane gas by chemical vapor deposition using hot metal filaments as a heat source, the apparatus comprising:
a pair of conductive electrodes, each electrode having a flat surface on a top portion thereof and a curved surface on an outer side thereof, and a plurality of metal filaments placed over both electrodes to extend between the electrodes and such that each filament is in contact with both the flat surface and the curved surface of each electrode, the apparatus further comprising an individual weight hung at each end of each filament to tension the filaments placed over the electrodes,
the apparatus further comprising conductive cover plates mounting a region of each filament to the flat surface such that when electrical power is supplied to the filaments no heat is generated in the regions thereof enclosed by the conductive cover plate and the flat surface.

Embodiments of apparatus of the invention enable the formation of diamond with large size without pre-stressing the metal filament to be curved lightly and without having an intricate subsidiary equipment such as springs, movable electrodes, a counterbalancing weight assembly or force regulators.

Conventionally, the metal filament used in synthesizing diamond is disposable. However, embodiments of the invention make it possible to use the filament repeatedly because repetitive changes can be naturally controllable. It is also easy to enlarge the size of diamond, and unnecessary to regulate precisely the instalments of filament for synthesizing diamond. As a result, the equipment for synthesizing diamond using hot filament has the simplified structure. Thereby, productivity and economy are improved.

With embodiments of the invention changes in the length of filament can be controlled without breakage resulting from its weight to maintain the tension applied to each filament although metal filament is changed in its length due to the change of temperature and has the brittleness due to its carburization.

Embodiments of the present invention will hereinafter be described, by way of example, with reference to the accompanying drawings, in which:
Figure 1 is a perspective, exploded, view of an embodiment of apparatus for synthesizing diamond using a chemical vapor deposition process;
Figure 2 is a view of the apparatus of Figure 1 in its assembled state; and
Figure 3 is a cross-sectional view of the apparatus of Figure 2.

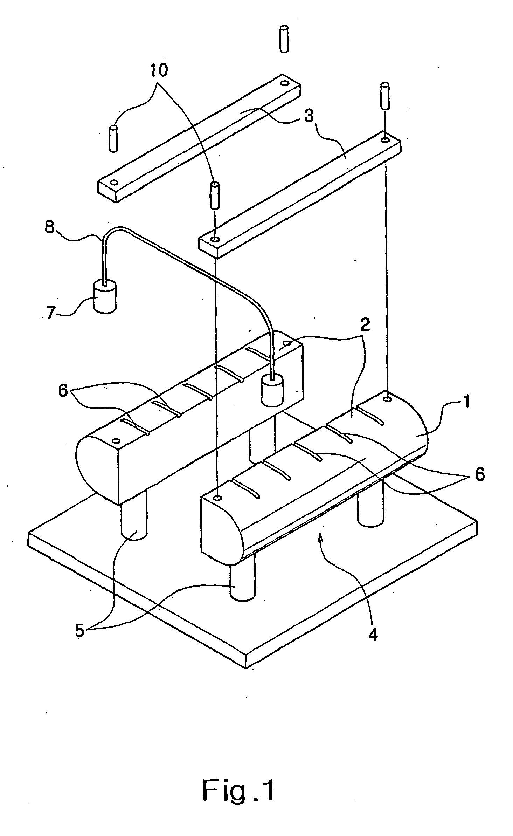

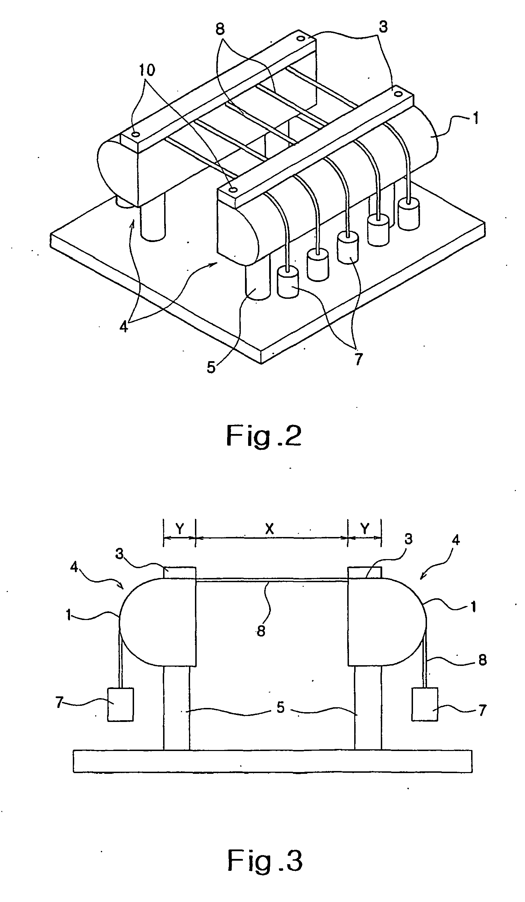

Figures 1 and 2 show apparatus for synthesizing diamond using a chemical vapor deposition process and illustrate the installation of filaments of the apparatus.

The apparatus comprises a pair of electrodes 4 which are each conductive and are located on a central base substrate. Each electrode 4 includes a flat surface 2 on the top side thereof and a curved surface 1 on the outer side thereof. On the flat surface 2 of each electrode 4 a plurality of slots 6 are formed which are spaced at predetermined intervals. A respective power supply member 5 is formed to fix each electrode 4 on the bottom portion of the electrode 4 and to supply power to that electrode. A plurality of metal filaments 8 each have a respective metal weight 7 hanging onto each end thereof. These weighted filaments 8 are located in respective slots 6 in the flat surfaces 2 of the electrodes 4. The filaments 8 are thus tightly hung between the electrodes 4, and each filament 8 is fixed with conductive cover plates 3.

The cover plates 3 ensure that each filament 8 is reliably in contact with the electrodes 4. Thus, each filament can be either in continuous contact with the slot 6 formed on the flat surface 2, or can be on the flat surface 2 of electrodes 4.

Pins 10 fix the cover plates 3 to the electrodes 4.

A plurality of slots 6 are formed on the flat surface 2 of the electrodes 4 so that the metal filaments 8 can be spaced at predetermined intervals and each filament 8 cannot come into contact with its neighbouring filaments.

Because the outer side of each electrode 4 is formed as a curved surface 1 each small and brittle filament 8 may be maintained without breakage resulting from heat expansion, contraction or abrupt fracture of transformation. The individual weights 7 apply tension to the filaments 8.

The curvature of the curved surface 1 may be adjusted in accordance with the diameter of the filament 8.

Each end of each filament 8, which has its own predetermined weight, is weighted with an individual metal weight 7 in order to tension the filament. When the filament, which will generate heat at a high temperature is heated, the filament is expanded by heat and thus slackens between the two electrodes 4. However, this slackening in the filament can be taken up by the tension due to the metal weights 7 hanging on each end of each filament 8. Thus, the filaments 8 can be maintained parallel with each other. In this respect, the filaments 8 are in smooth contact with the flat surface 2 and the curved surface 1 without being fixed so that the filaments can be freely moved to accommodate changes due to temperature change.

The conductive cover plate 3 can solve problems such as heat expansion, contraction and brittleness due to the carburization of the filaments without breakage by its weight having only gravitation.

Operation of the apparatus described above will now be explained with reference to Figure 3.

When power is supplied via the power supply member 5, the filaments 8 generate heat at high temperature in the region "X" as shown in Figure 3.

The filaments do not generate heat in the region "Y" of Figure 3 because the filaments 8 are in contact with the flat surface 2 or with the slot 6 and the cover plate 3 fixes the filaments in position.

Accordingly, the filaments 8 maintain the metal characteristic as it is and do not generate heat in the region "Y" and thereby carburization of the filaments in that region is prevented.

Each filament 8 is carbonized in the region "X", as each filament 8 is heated to a temperature of over 2000°C by the supply of power, whereby diamond is synthesized. However, the carbonized filaments thereby have the brittleness of ceramics.

Due to the brittleness by carburization, the filaments 8 may be easily broken and fractured by small impact. When this occurs, the broken filament cannot fulfil its role as a heat source.

However, the filaments 8 of the apparatus of Figure 3 are maintained in the region "Y", to have the 'as is' metal characteristic, in spite of the filaments' transformation resulting from thermal expansion, contraction and carburization due to the rise of the temperature. As a result, breakage of the filaments 8 is prevented because fracture of the filaments 8 by longitudinal thermal expansion would be expected to occur in the region "Y" in which the metal characteristic is maintained.

In synthesizing diamond, the filaments are usually broken by the change in temperature during thermal expansion or contraction by heating and cooling. Each filament 8 is continuously changed in its length corresponding to the temperature in spite of the regulation of the filament under the same condition of rising temperature.

For example, the temperature of each filament 8 locally increases or decreases when a gas is injected in synthesizing diamond or when temperature is properly adjusted to synthesize diamond. Unless changes in length of the filament are regulated according to changes in temperature, the carbonized filament, which is brittle, is broken.

If there is no region where the filament does not generate heat, the filament is changed in its length at high temperature, and the stress due to the fracture occurs in the region where the carbonized filament is brittle. As a result the filament 8 is broken.

However, with apparatus of the invention, each filament 8 maintains its metal characteristic in the region "Y" as shown in Figure 3. The region "Y" is able to cope with the change in length of the filament and the stress due to the fracture and this prevents breakage of the filament 8.

Examples utilising embodiments of the invention are now described.

### Example 1

The radius of the curved surface is 20mm, the curved surface on one side of the fixed electrodes whereon the filament is hung. The distance between two electrodes is 25cm. The comparison chart according to (1) the diameter of the filament placed over each electrode, (2) the size and the existence of the region "Y" of the flat surface parallel with the filament and (3) the size of the weight applying the tension to each filament is as follows:
Comparison Chart 1.
The possibility of reusing the filament and the breakage of the filament according to (1) its diameter, (2) the weight and (3) the existence of the flat surface region "Y" in electrodes

| **Diameter** | **Weight** | **Size of region** | **Result on Filament** |
|---|---|---|---|
| **(mm)** | **(gram)** | **"Y"** | |
| 0.05 | 1 | 0 | Breakage |
| 0.05 | 1 | 10 | Reusable |
| 0.05 | 5 | 10 | Breakage |
| 0.1 | 1 | 0 | Breakage |
| 0.1 | 5 | 10 | Reusable |
| 0.1 | 10 | 10 | Breakage |
| 0.2 | 5 | 0 | Breakage |
| 0.2 | 10 | 10 | Reusable |
| 0.2 | 15 | 10 | Reusable |
| 0.2 | 30 | 15 | Breakage |
| 0.3 | 5 | 0 | Failure in being level |
| 0.3 | 20 | 0 | Breakage |
| 0.3 | 20 | 10 | Reusable |
| 0.3 | 50 | 15 | Breakage |
| 0.5 | 20 | 0 | Failure in being level |
| 0.5 | 40 | 0 | Breakage |
| 0.5 | 40 | 15 | Reusable |
| 0.7 | 100 | 15 | Reusable |

As shown in the above comparison chart, when electrodes having no region "Y" are used, almost all of the filaments are broken by 1∼3 thermal expansion by heating and contraction by cooling.

However, when there is the region "Y" which is the flat surface region of filament in electrodes, the filament may be continuously reusable.

In addition, there are weights that may enable the filament to have the optimum performance according to its diameter. If the filament is not fastened by more tension than a predetermined degree of weights, it is impossible to adjust the slackening filament resulting from the weight of the filament to be level.

When the tension is applied to the filament with more weight than it needs, the filament is broken by its continuous transformation at high temperature.

### Example 2

Diamond of insert-type tools is coated by setting apparatus of the invention as follows.

The radius of the curved surface is 20mm, the curved surface of the fixed electrodes whereon the filament is hung. The region "Y" of the flat surface is 10mm, the flat surface formed on the top portion of electrodes. The distance between electrodes is 25cm. 15 tungsten filaments each having a diameter of 0.2mm are used. Both ends of each tungsten filament are weighted with metal weights of 10g. Each filament smoothly hung to the electrodes is arranged in a respective slot formed on the flat surface of the electrode. Each filament is not exactly parallel to its neighbouring filament due to the rigidity of tungsten filament.

After the tungsten filament is installed, power is supplied so that the filament begins to be carbonized with rising temperature. The mixed gas consisting of methane of 2% and hydrogen of 98% is also supplied at a pressure 5333Pa (40 torr). The filament is longitudinally expanded by thermal expansion, and slackened by its weight. If it is heated to the temperature of 2000°C in the middle portion of the filament (the middle portion between electrodes), the filament is slackened by about 10mm.

However, the slackened filament gradually becomes horizontal because it is given the tensile stress due to the tension of the weights on the filament. The filament is just carbonized in the region "X" of Figure 3 as described above.

After it is, under this condition, carbonized by the heat for about 10 hours, the filament is cooled by cutting off the power. The filament is not carbonized in the region "Y" of the flat surface in Figure 3.

After the filament is cooled, the substrate is mounted under the filament. While the insert tool is put on the top portion of the substrate, diamond is coated.

While the mixed gas as described above is supplied with the pressure of 5333Pa (40 torr), the power is supplied so that the filament may have the temperature of 2200°C and the substrate of 850°.

The carbonized filament maintains its horizontality due to the weights on the filament. Before it is settled at a predetermined temperature or when the temperature is rising, the filament is repeatedly expanded and contracted by its heat.

Although the filament may have the thermal expansion larger than in its carburization, the fracture stress resulting from the change in its length is occurred in the region "Y" of the uncarbonized flat surface, thereby the filament is not broken and may generate heat to a predetermined temperature.

After diamond is coated and then cooled, the coated insert tool is taken out of the synthesizing equipment. An insert tool that will be newly coated is then re-put in the equipment. In the same way, as described above, the diamond is coated.

Although the filament is repeatedly expanded and contracted in the same way, the diamond may be coated without breakage of the filament. Based on the time of 20 hours in coating diamond at one time, the diamond is repeatedly coated about ten times. However, the filament may be reusable without breakage.

Additionally, if silicon wafer is put on the substrate instead of the insert tool under the same condition as described above, the uniform film of diamond having the thickness of ± 10% may be synthesized on the wafer having the diameter of 10.16cm (4 inches).

The apparatus described and illustrated for forming diamond via a chemical vapor deposition process using hot metal filament can solve the most important problem of the breakage of the filament resulting from its heat expansion, contraction and carburization. Thus, the filament can have a larger size when synthesizing diamond. Most of all, it is possible to use the filament repeatedly unlike the conventional filament, resulting in a simplification of the process for coating diamond. This improves the competitiveness for synthesizing diamond.

## Claims

1. A method for synthesizing diamond based on hydrogen and methane gas by chemical vapor deposition, the method using hot metal filaments as a heat source, the method using apparatus comprising a pair of conductive electrodes (4), each electrode (4) having a flat surface (2) on a top portion thereof and a curved surface (1) on an outer side thereof, and a plurality of metal filaments (8) placed over both electrodes (4) to extend between the electrodes (4) and such that each filament is in contact with both the flat surface (2) and the curved surface (1) of each electrode (4), wherein each end of each filament (8) is weighted with individual weights (7) in order to tension the filaments placed over the electrodes (4), the apparatus also comprising conductive cover plates (3) mounting a region (Y) of each filament (8) to the flat surface (2), the method comprising supplying electrical power to the filaments (8) to heat them and to synthesize diamond, wherein the region (Y) of each filament (8) enclosed by the conductive cover plate (3) and the flat surface (2) does not generate heat.

2. Apparatus for synthesizing diamond based on hydrogen and methane gas by chemical vapor deposition using hot metal filaments as a heat source, the apparatus comprising:
a pair of conductive electrodes (4), each electrode (4) having a flat surface (2) on a top portion thereof and a curved surface (1) on an outer side thereof, and a plurality of metal filaments (8) placed over both electrodes (4) to extend between the electrodes (4) and such that each filament is in contact with both the flat surface (2) and the curved surface (1) of each electrode (4),
the apparatus further comprising an individual weight (7) hung at each end of each filament (8) to tension the filaments placed over the electrodes (4),
the apparatus further comprising conductive cover plates (3) mounting a region (Y) of each filament (8) to the flat surface (2) such that when electrical power is supplied to the filaments (8) no heat is generated in the regions (Y) thereof enclosed by the conductive cover plate (3) and the flat surface (2).

3. Apparatus as claimed in Claim 2, wherein a plurality of slots (6) are formed parallel with each other at predetermined intervals along the flat surface (2) of each electrode (4), and one of the plurality of filaments is placed over each slot (6).

## Patentansprüche

1. Verfahren zur Diamantsynthese auf der Grundlage von Wasserstoff und Methangas durch chemische Dampfabscheidung, wobei bei dem Verfahren als Wärmequelle heiße Metallfilamente zur Verwendung kommen, wobei bei dem Verfahren eine Vorrichtung zur Verwendung kommt, die ein Paar leitender Elektroden (4) umfasst, wobei ein oberer Abschnitt jeder Elektrode (4) eine flache Oberfläche (2) und eine Außenseite eine gekrümmte Oberfläche (1) und eine Vielzahl von Metallfäden (8) aufweist, die so über den beiden Elektroden (4) angeordnet sind, dass sie sich zwischen den Elektroden (4) erstrecken und dass jedes Filament in Kontakt sowohl zur flachen Oberfläche (2) als auch zur gekrümmten Oberfläche (1) jeder Elektrode (4) steht, wobei jedes Ende eines jeden Filaments (8) mit Einzelgewichten (7) beschwert ist, um die über den Elektroden (4) angeordneten Filamente zu spannen, wobei die Vorrichtung weiterhin leitende Deckplatten (3) zur Anbringung eines Bereich (Y) jedes Filaments (8) an der flachen Oberfläche (2) aufweist, wobei das Verfahren das Liefern elektrischen Stroms an die Filamente (8) umfasst, um diese aufzuheizen und Diamanten zu synthetisieren, wobei der Bereich (Y) jedes Filaments (8) von der leitenden Deckplatte (3) umschlossen ist und die flache Oberfläche (2) keine Wärme erzeugt.

2. Vorrichtung zur Diamantsynthese auf der Grundlage von Wasserstoff und Methangas durch chemische Dampfabscheidung, wobei heiße Metallfilamente als Wärmequelle zur Verwendung kommen, wobei die Vorrichtung umfasst:
ein Paar leitender Elektroden (4), wobei ein oberer Abschnitt jeder Elektrode (4) eine flache Oberfläche (2) und eine Außenseite eine gekrümmte Oberfläche (1) und eine Vielzahl von Metallfilamenten (8) aufweist, die so über den beiden Elektroden (4) angeordnet sind, dass sie sich zwischen den Elektroden (4) erstrecken und dass jedes Filament in Kontakt sowohl zur flachen Oberfläche (2) als auch zur gekrümmten Oberfläche (1) jeder Elektrode (4) steht,
wobei die Vorrichtung weiterhin ein Einzelgewicht (7) umfasst, das an jedem Ende jedes Filaments (8) aufgehängt ist, um die über den Elektroden (4) angeordneten Filamente zu spannen;
wobei die Vorrichtung weiterhin leitende Deckplatten (3) zur Anbringung eines Bereich (Y) jedes Filaments (8) dergestalt an der flachen Oberfläche (2) umfasst, dass beim Liefern elektrischen Stroms an die Filamente (8) in ihren von der leitenden Deckplatte (3) und der flachen Oberfläche (2) umschlossenen Bereichen (Y) keine Wärme erzeugt wird.

3. Vorrichtung nach Anspruch 2, wobei eine Vielzahl von Schlitzen (6) in vorbestimmten Abständen entlang der flachen Oberfläche (2) jeder Elektrode (4) parallel zueinander ausgebildet sind und eines der Vielzahl von Filamenten über jedem Schlitz (6) angeordnet ist.

## Revendications

1. Procédé de synthèse de diamant à partir d'hydrogène et de méthane gazeux par dépôt chimique en phase vapeur, le procédé utilisant des filaments métalliques chauffés comme source de chaleur, le procédé utilisant un appareil comprenant une paire d'électrodes conductrices (4), chaque électrode (4) ayant une surface plate (2) sur une partie supérieure de celle-ci et une surface courbe (1) sur un côté externe de celle-ci, et une pluralité de filaments métalliques (8) placés sur les deux électrodes (4) pour s'étendre entre les électrodes (4), et de telle sorte que chaque filament soit en contact à la fois avec la surface plate (2) et la surface courbe (1) de chaque électrode (4), dans lequel chaque extrémité de chaque filament (8) est lestée avec des poids individuels (7) afin de tendre les filaments placés sur les électrodes (4), l'appareil comprenant également des plaques conductrices de recouvrement (3) pour monter une région (Y) de chaque filament (8) sur la surface plate (2), le procédé comprenant l'alimentation en énergie électrique des filaments (8) pour les chauffer et synthétiser un diamant, dans lequel la région (Y) de chaque filament (8) délimitée par la plaque conductrice de recouvrement (3) et la surface plate (2) ne génère pas de chaleur.

2. Appareil de synthèse de diamant à partir d'hydrogène et de méthane gazeux par dépôt chimique en phase vapeur utilisant des filaments métalliques chauffés comme source de chaleur, l'appareil comprenant :
une paire d'électrodes conductrices (4), chaque électrode (4) ayant une surface plate (2) sur une partie supérieure de celle-ci et une surface courbe (1) sur un côté externe de celle-ci, et une pluralité de filaments métalliques (8) placés sur les deux électrodes (4) pour s'étendre entre les électrodes (4), et de telle sorte que chaque filament soit en contact à la fois avec la surface plate (2) et la surface courbe (1) de chaque électrode (4),
l'appareil comprenant en outre un poids individuel (7) accroché à chaque extrémité de chaque filament (8) pour mettre sous tension les filaments placés sur les électrodes (4),
l'appareil comprenant en outre des plaques conductrices de recouvrement (3) pour monter une région (Y) de chaque filament (8) sur la surface plate (2), de sorte que quand de l'énergie électrique est fournie aux filaments (8), aucune chaleur n'est générée dans leurs régions (Y) délimitées par la plaque conductrice de recouvrement (3) et la surface plate (2).

3. Appareil selon la revendication 2, dans lequel plusieurs encoches (6) sont formées parallèles les unes par rapport aux autres à des intervalles prédéterminés le long de la surface plate (2) de chaque électrode (4), et l'un de la pluralité de filaments est placé sur chaque encoche (6).
